# EUROPEAN PATENT APPLICATION

(11) **EP 0 561 567 A2**
(43) Date of publication of application: **22.09.1993**
(21) Application number: 93301890.5
(22) Date of filing: 12.03.1993
(51) Int. Cl.: C22C 21/00, H01L 23/48, C22C 1/02, C23C 14/18, C22F 1/04

(54) **Alloys containing gallium and aluminum as semiconductor electrical contacts**

(30) Priority: 17.03.1992 US 851729
(71) Applicant: WISCONSIN ALUMNI RESEARCH FOUNDATION, Madison, WI 53707-7365 (US)
(72) Inventor: Chang, Y. Austin, Middleton, Wisconsin 53562 (US); Jan, Chia-Hong, Portland, Oregon 97229 (US)
(74) Representative: George, Roger David

(57) **Abstract**

Alloys are disclosed which are suitable for use as electrical contacts on semiconductor substrates comprised of a compound of a Group III element and a Group V element. The alloy contains gallium, aluminum and a Group VIII selected from among Ni, Co, Ru, Rh and Ir with Ni being presently most preferred. The preferred substrate is gallium arsenide. The methods contemplated by the present invention include the steps of depositing (preferably by sputtering) the alloy on a semiconductor substrate and then annealing. Resulting semiconductor devices display excellent thermal stability and improved performance characteristics.

## Description

### Field of the Invention

This invention relates to alloys of certain Group VIII metals with aluminum and gallium that are useful as electrical contacts with semiconductor substrates of the gallium arsenide type, to devices made therewith and to methods for making the same.

### Background of the Invention

This invention was made with United States Government support awarded by the Department of Energy (DOE), Grant #DE-FG02-86ER452754. The United States Government has certain rights in this invention.

Semiconducting crystalline GaAs substrates can provide faster circuits, up to about 6 times faster, than semiconducting Si substrates because of greater electron and electron hole mobility. A problem encountered with such GaAs substrates is that they tend to be very reactive with metals coated onto their surfaces, such as is conventionally done in forming solid state devices. Metals (including alloys) are needed which are useful as electrical contacts with such substrates and which are also substantially nonreactive therewith.

The fabrication of, for example, a planar n-channel GaAs MESFET (metal semiconductor field effect transistor or Schottky-gate) IC (integrated circuit) device involves many of the same process steps as with silicon IC devices. Among these steps are cleaning, oxidizing, masking, etching, implanting, annealing, metalizing and dicing. For example, such a device is prepared by sputter-coating appropriate metal contacts at desired locations on a single crystal GaAs substrate or chip to form the source, drain and gate. Dopants are introduced by ion implantation into the substrate. Thereafter, the whole chip is annealed, typically at about 800°C for about 10 minutes, to diffuse the dopants into the GaAs and to heat process the contacts, thereby forming the desired device structure.

The metal used in forming the contacts must survive the annealing without degrading the electronic characteristics of the device. The fabrication and characteristics of GaAs MESFETs are described, for example, in Chapter 11 at page 414-421 of the book "Analysis and Design of Digital Integrated Circuits" by Hodges S. Jackson, published by McGraw-Hill Co., New York (1988).

Tungsten and tungsten in combination with titanium and/or silicon have previously been used as the contact metals in MESFETs to form Schottky barriers leading to Schottky diodes. Schottky barriers are used to form transistor gates and as diodes for performing logic and level shifting. However, these prior art metals and metal alloys break down in unsatisfactorily short time periods for practical widespread industrial use. This breakdown is believed to be associated with reaction of these metals and alloys with GaAs. The gross mismatch of atomic structures evidently forces the metal to grow with internal grain boundaries that act as fast paths for atoms to move along. Thus, such contact metals move into the GaAs and destroy the electrical properties of the device even at normal operating temperatures so that the life of the device is drastically reduced. This problem of contact stability has hindered the development of this technology.

MBE (molecular beam epitaxy) grown films of NiAl [(T. Sands, Appl. Phys. Lett., 52(3), 197 (1988), Sands et al., Appl. Phys. Lett., 52(15), 1216 (1988), Sands et al., Appl. Phys. Lett., 52(16), 1338 (1988) and Sands et al., Mater.Sci. Report, (1991)] and MBE grown films of NiGa [(Guivarc'h et al., Electronic Letters, 23(19), 1004 (1987) and Guivarc'h et al., J. of Crystal Growth, 95, 427 (1989)] have been reported, but such films on GaAs are not suitable for use as electrical contacts because of thermal stability problems. Ternary and higher alloys of Ni, Al and Ga were not previously known and evidently were thought not to exist.

New and improved electrical contacts for semiconductor substrates of the GaAs type are needed. The present invention fulfills this need.

### Summary of the Invention

In one aspect, the present invention provides a new class of alloys of certain Group VIII transition metals with gallium and aluminum.

The alloys are useful as electrical contacts, especially as gate electrodes, on surfaces of semiconducting single crystalline compounds of the formula AlᵥGa₁₋ᵥAs where v is a positive number ranging from and including 0 through 1 inclusive. The present invention further provides a process for making the new alloy.

In another aspect, the present invention provides a new and very useful class of semiconductor devices which have substrates of semiconducting compounds as defined above and which devices each incorporate at least one electrical contact that is comprised of such an alloy. The present invention further provides processes for making these new alloys.

The new alloys are represented by the formula:

(1) [ΣM](AlₓGa₁₋ₓ)

where:
ΣM is at least one metal selected from among the Group VIII metals consisting of Ni (nickel), Co (cobalt), Ru (ruthenium), Rh (rhodium) and Ir (iridium); and
x is a positive number ranging from greater than 0 to less than 1.

Preferably, in one preferred class of formula (1) compounds, [ΣM] has the formula [M¹_{y}M²_{1-y}] wherein M is as defined above, M¹ is different from M², and y is a positive number ranging from and including 0 through 1. Preferably, y is greater than 0 and less than 1.

In another preferred class of formula (1) compounds, [ΣM] is [M¹_{y} M²₂ M³_{1-y-z}] where y is a positive whole number from and including 0 through 1; z is a positive whole number from and including 0 through 1; the sum of y, z and [1-y-z] in any given compound is always 1; and M¹, M² and M³ each differ from the others thereof. Preferably, y and z are each in the range of greater than 0 to less than 1.

Among the metals in the foregoing definition of M, nickel and cobalt are presently preferred when more than one metal is present in ΣM; and, when only a single metal of Group VIII is present in ΣM in an alloy of formula (1), nickel is presently most preferred.

In general, with regard to formula (1), x is preferably a number that is greater than about 0.35 and less than about 0.60. A presently most preferred value for x is about 0.5.

By using the alloys provided herein as electrical contacts for devices based on such semiconducting compounds, especially gallium arsenide (GaAs), the previously indicated problems of the prior art concerning contact temperature stability and metal inertness are overcome. Electrical contacts comprised of such alloys display excellent Schottky barrier properties. Such alloys are useful in forming Schottky diodes, transistors and the like on such semiconducting compounds.

Thus, the present invention provides a new class of ternary and higher alloys of certain Group VIII metals with Al and Ga. This class is not predicted or suggested by the prior art, and its members are surprisingly suitable for use as electrical contacts in semiconductor devices, particularly those of the single crystalline GaAs substrate digital IC type. Such devices can be used in high speed digital integrated circuits, and, when so used, display excellent temperature stability, duty life and other desirable performance characteristics compared to corresponding prior art devices.

The present invention further provides a new class of semiconductor devices whose members each include at least one single crystal semiconducting substrate compound as defined above and have at least one substrate surface portion thereof that is in electrically conductive association with at least one electrical contact comprised of at least one alloy of the present invention. Presently preferred semiconductor devices of this invention are classifiable as transistors, and a presently most preferred device is a MESFET wherein the semiconductor substrate is comprised of a single crystal of gallium arsenide (GaAs) and wherein the substrate is provided with at least one electrical contact that is comprised of an alloy of this invention. Preferably, in such a preferred device, the alloy has the formula Ni(AlₓGa₁₋ₓ) wherein x is as defined above.

The present invention provides methods of making the alloys of this invention and also electrical contacts comprised of such alloys on a surface portion of a semiconductive substrate. A presently preferred contact formation method involves sputtering an alloy of this invention upon a substrate to deposit a thin layer (or film) thereof. The deposition is usually on a localized substrate surface area. Subsequently, the resulting layer-coated substrate is preferably annealed.

One feature and advantage of this invention is that, in general, deposition techniques previously known to the prior art can be adapted to fabricate metal contacts comprised of alloys of this invention. Thus, the development of entirely new deposition techniques is not necessary.

In accord with a preferred feature of the present invention, an electrical contact comprised of an alloy of this invention can be optionally but preferably overcoated with a layer of tungsten. Such an overcoated layer appears to enhance the capacity of an electrical contact to make exterior interconnection with a conductor, such as a wire or the like.

Semiconductor devices having such a substrate and such contacts display superior stability characteristics during and after annealing and also display excellent performance and duty life characteristics.

Presently preferred semiconductor devices so comprised offer improved Schottky barrier enhancement compared with prior art devices.

Other and further objects, features, purposes, advantages, arrangements, embodiments and the like that are associated with the present invention will be apparent to those skilled in the art from the following detailed description of the invention taken with the accompanying drawings and appended claims.

### Brief Description of the Drawings

In the drawings:
Fig. 1 is a diagrammatic perspective fragmentary vertical sectional view of one embodiment of a device of the present invention which incorporates an electrical contact comprising an alloy of this invention;
Fig. 2 is a view similar to Fig. 1, but showing another device embodiment;
Fig. 3 is a graph of current flux (Amperes/cm²) versus voltage (Volts) at three separate annealing temperatures for Ni(Al_{0.5}Ga_{0.5})/GaAs contacts; and
Fig. 4 is a graph of Schottky barrier height (eV) versus annealing temperature (degrees C) comparing three alloy compositions used as contacts to a gallium arsenide substrate.

### Detailed Description of the Invention

### (a) Alloys and their Preparation

Alloys of the present invention are conveniently prepared by various procedures. For example, one can use as starting materials finely divided powders of the individual elemental metals or of subcomponent alloys which each preferably have a purity greater than about 99.99 weight percent. Suitable starting powders can be obtained from various commercial sources. Suitable powder component particle sizes are preferably in the size range of about 300 mesh although smaller and larger sized particles can be used, if desired. The desired amount of each elemental powdered metal is weighed out, and the respective so weighed metals are admixed together and then pressed into a pellet or the like. Suitable compressing pressures are in the range of about 500 to about 800 psi (pounds per square inch) with a present preference being about 600 psi although higher and lower compression pressures can be used, if desired.

Preferably, each resulting pellet is then placed in an inert vessel, such as an ampoule comprised of quartz or the like. Preferably, the interior of each vessel is then evacuated. Suitable subatmospheric pressures are in the range of about 10⁻³ to about 10⁻⁵ Torr with a pressure of about 10⁻⁴ Torr being presently preferred. Higher and lower subatmospheric pressures can be used, if desired. Thereafter, each so evacuated vessel (such as an ampoule) with a pellet therein is sealed.

Then, each pellet in its associated sealed and evacuated vessel is preferably annealed at a desired temperature for a desired period of time. Suitable temperatures are in the range of about 1050 to about 1400°C, and suitable times are in the range of about 1.5 to about 15 days (about 30 to about 360 hours).

Thereafter, it is now preferred to cool and remove each resulting pellet from its associated vessel, and to pulverize each resulting pellet into a powder. A present preference is for the component particles of such a resulting powder to have sizes in the range of about 600 mesh although smaller and larger sized particles can be used if desired.

Next, the pulverized material from a pellet is again pressed into a pellet or the like using a compressing pressure such as indicated above. Preferably, each resulting pellet is then again placed in an inert vessel, which is then evacuated and sealed as described above.

Then, each pellet in its vessel is preferably further annealed at a desired temperature for a desired period of time. Suitable temperatures are in a range such as indicated above, and suitable times are conveniently and preferably in the range of about 3 to about 30 days (about 70 to about 720 hours), although shorter and longer times can be used, if desired.

Thereafter, it is now preferred to quench each resulting pellet in its vessel. A suitable quench procedure is to immerse each vessel in ice water having a temperature in the range of about 0 to about 5°C. Each pellet is then removed from its vessel.

When, for example, the product pellet has a total mass of about 0.5 g (gram) and is to be analyzed, one presently preferred procedure is to cut the pellet into about two parts. One part is preferably subjected to analysis using an X-ray diffractometer, or the like. Another part is preferably mounted in an epoxy resin or the like and then is metallographically cross-sectioned.

Compositional analysis is conveniently accomplished using, for example, wavelength dispersive spectroscopy (WDS) of X-rays which can be accomplished using, for example, an SEMQ electron microprobe, such as is available commercially from Applied Research Lab.

Sometimes alloy samples can be prepared by first annealing them above their melting temperatures to achieve homogeneity. Subsequently, the samples are maintained and annealed at an elevated temperature that is below the melting temperature and that is preferably at an annealing temperature that is within the foregoing range for a desired period of time, such as a time that is within the range of about 7 to about 30 days. A present time preference is about 30 days using a temperature in the range of about 600 to about 800°C. Thereafter, characterization can be carried out in a manner as described above.

For differential thermal analysis purposes, the alloy samples are conveniently prepared from starting metal powders pelletized and then sealed in quartz ampoules or the like, in the foregoing manner. The samples are first preferably annealed at about 600°C for about 3 days to achieve reaction between the metals after which the heating temperature is raised higher than the melting temperature of the alloy (usually and preferably at temperatures of about 1200°C) for purposes of homogenization for a time in the range of about 7 to about 30 days. Thereafter, the temperature is slowly cooled to an annealing temperature that is conveniently and preferably about 600°C where the sample is held for a time of preferably several weeks to eliminate any possible segregation before quenching to room temperature.

Alloys of the present invention prepared as described above can be used for deposition purposes upon semiconductive single crystalline substrates as described herein.

In an alternative procedure, alloys of the present invention can be prepared in an in situ manner by a metal vapor deposition procedure. The individual component elemental metals of a desired alloy of the invention which each have a purity preferably greater than about 99.99 weight percent are each simultaneously but separately vaporized in a vacuum chamber at rates which will approximately provide the respective proportions desired in a particular alloy embodiment of this invention upon vapor codeposition on a substrate surface. Sputtering is preferred using a procedure such as described herein.

A present preference is to generally employ the vacuum conditions of vaporizing described herein for alloy sputtering and deposition upon semiconductor substrate surfaces. As a result, a codeposited layer so produced upon a selected substrate comprises an alloy of this invention. For purposes of electrical contact usage, such a codeposited layer has a thickness in the range disclosed herein for an electrical contract comprised of an alloy of this invention.

For purposes of use as a source of vaporizable alloy in the manufacture of an electrical contact for a solid state device, preformed alloys of this invention are preferably in the form of a solid, such as a pellet that is formed before the preformed alloy is subjected to a vaporization procedure for electrical contact formation purposes.

Examples of alloys of formula (1) above are shown in Table I in subgeneric groups containing three, four and five component metals with each subgeneric group being illustrated by a specific accompanying example. The alloys are produced by the teachings herein described.

That the alloys of this invention are homogeneous alloys is shown by various means known to the art, especially x-ray diffraction and microprobe data.

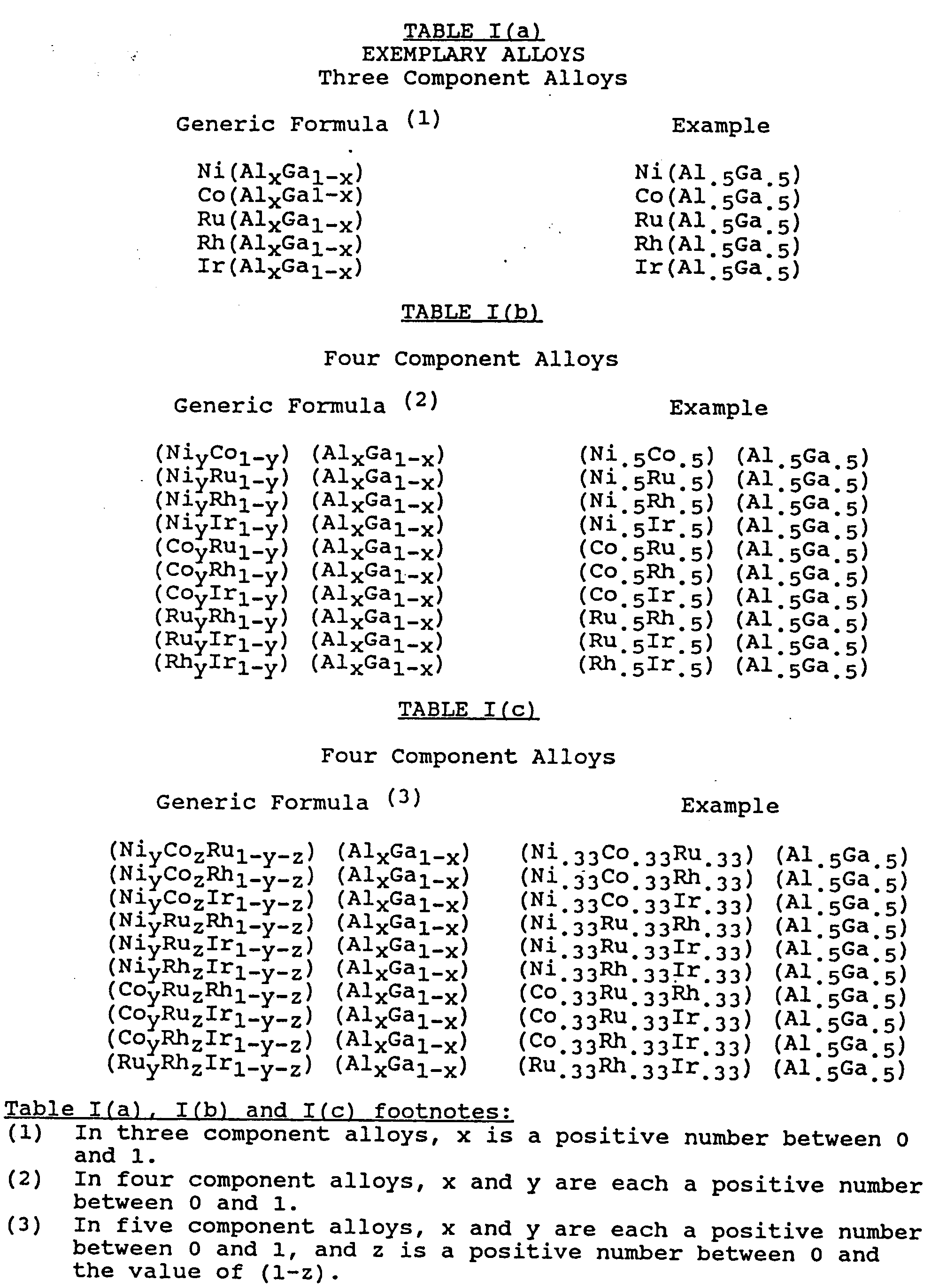

### (b) Deposition on a Substrate

An alloy of formula (1) prepared by a process as described above can be deposited upon various substrates. Such a procedure is utilized in preparing an electrical contact on a semiconductor substrate. Presently preferred are substrates of a semiconductive single crystal structure such as indicated above. Deposition can be achieved by any conventional procedure including, for example, vacuum vapor thermal deposition, electron beam bombardment, sputtering, and the like. Sputtering is presently preferred.

Embodiments of these substrates are available commercially, and the preparation of such semiconductive substrates is known in the prior art.

While single crystal gallium arsenide (GaAs) substrates are presently particularly preferred, suitable other preferred substrates can be used, such as, for example, aluminum gallium arsenide and aluminum arsenide.

Initially, a body of substrate material is formed or configured into a desired shape and size (wafer, disc, chip or the like). At least one surface thereof is prepared for deposition by a conventional procedure, such as a procedure utilizing solvent washing, polishing, and/or the like. A present preference is solvent washing.

Sputtering, for example, is conveniently carried out using a vacuum in the range of about 10⁻² to about 10⁻¹¹ Torr. A present preference is to employ the sputtering equipment that is available commercially from Iontek, Inc. of Fort Collins, CO and to use the sputtering conditions recommended generally by this company for use of their equipment.

Preferably, a sputter deposition procedure uses an ionized gas which has been accelerated under an electric or magnetic field to bombard the alloy source target, thereby "knocking off" alloy molecules in a vaporized state from a source body from which vaporized molecules drift to, and deposit upon, a spatially adjacent surface of the single crystal substrate.

Sputtering is thus distinguishable from thermal evaporation, electron beam evaporation and the like because in the latter methods the alloy source target is treated to "boil off" the alloy.

Instead of employing a preformed alloy of this invention as a vaporizable starting material for layer deposition upon a substrate surface, an alloy of this invention can be formed in situ by codeposition of the component metals being used to form an alloy of formula 1 as indicated above. For example, one can use the foregoing sputtering vacuum conditions and simultaneously but separately sputter the respective alloy component metals, such as, for example, substantially pure nickel, and aluminum and gallium, at rates which produce a desired approximate mole ratio, such as about 1:0.5:0.5, respectively, thereby to produce a codeposited layer of the alloy Ni(Al_{0.5}Ga_{0.5}) upon a desired substrate surface.

However, because of sputter rate control difficulties that can occur in the codeposition procedure, it is presently preferred to utilize preformed alloys of this invention in forming electrical contacts thereof.

Regardless of the method of depositing, the thickness of a layer or film of alloy so deposited upon a substrate surface is typically in the range of about 40 to about 200 nm, and, more preferably, is in the range of about 50 to about 100 nm. Thicker and thinner layers can be used if desired. Electrical contacts utilizing a layer of an alloy of this invention typically have a size such that the gross exposed surface area thereof is typically in the range of about 10⁻⁶ to about 10⁻² mm² although contacts with larger or smaller surface areas can be used, if desired.

Alloys of this invention, and semiconductor device electrical contacts of this invention that are comprised thereof, are thermally stable. Thus, after being deposited on a semiconductor substrate of the class defined above and subsequently being subjected to annealing (under conditions such as described herein), a deposited layer is believed to display no appreciable tendency to react with the substrate. For example, in the case of a GaAs substrate, even after exposure to a temperature of at least about 800 degrees C applied for a time of at least about 10 minutes, no appreciable change with alloy or in the semiconductor electrical properties appears to have occurred.

After alloy deposition upon a substrate, the alloy deposit or layer, particularly when in the form of a localized electrical contact, is preferably overcoated with a layer of tungsten before annealing. The thickness of the tungsten layer can vary. A present preference is to vapor deposit (preferably by sputtering) a tungsten layer of about 10 to about 20 nm in thickness over an alloy layer. The tungsten layer provides a smoother surface morphology and better capacity for achieving electrical contact exteriorly (as with a contacting wire or the like) for reasons which are not yet altogether clear.

If desired, successive layers of different respective alloys of this invention can be deposited upon a single contact region of a substrate to produce an electrical contact.

As those skilled in the art will readily appreciate, in making an electrical contact, an alloy of this invention is typically deposited only on a predetermined localized area of a substrate surface. To achieve this result, a photolithographic procedure is preferably used. Thus, the predetermined surface region of the substrate is conveniently coated with a layer of a conventional photoresist composition, such as, for example, one which is commercially available under the trade designation "MF-321".

The so called substrate surface is then covered by a conventional EBES (electron beam exposure system) mask or the like. The mask is characteristically opaque except for a pattern of circular or elongated holes therein which are arranged at predetermined locations. Ultraviolet light is impinged against the mask to image the photoresist layer in the hole area(s). The resulting imaged layer is then contacted with a conventional developer solution. After development, the imaged hole area(s) on the substrate surface are exposed to alloy vapors while the adjacent areas remain covered by a layered deposit of developed photoresist material. The resulting alloy coated substrate surface is then removed from the deposition chamber and placed in a solution which removes the layered deposit of photoresist composition, but which leaves the locally deposited areas of alloy on the desired location(s) of the substrate surface.

### (c) Annealing

A substrate which has an alloy deposited thereon according to this invention is preferably subjected to annealing. In general, annealing is conveniently carried out in an oxygen-free (inert) atmosphere by heating the alloy-coated substrate to a temperature that is in the range of about 450°C to about 950°C for a time that is in the range of about 10 to about 200 minutes. A present preference is to employ a time of about 10 minutes.

Illustrative specific conditions and procedures such as are typically used for preparing particular semiconductor devices, and such as are used in the preparation of a MESFET having at least one contact that is comprised of an alloy of this invention, are hereinbelow provided.

It is theorized (and there is no intent herein to be bound by theory) that, during the annealing, interdiffusion occurs to a very limited extent in the interfacial region between the alloy and the substrate surfaces, but that such interdiffusion is insufficient to substantially alter desired electrical properties since the thin-films and the substrate are near thermodynamic equilibrium.

### (d) Electrical Contacts

As those skilled in the art will appreciate, the alloys of this invention can be used in a wide variety of semiconductor devices as electrical contact layers.

In general, a semiconductor device which incorporates an alloy of this invention has a monocrystalline semiconductive substrate that is characterized by the formula AlᵥGa₁₋ᵥAs wherein v is a positive number ranging from and including 0 through 1 inclusive and is in the form of a wafer or the like.

The substrate has at least one first metallic electrical contact electrode that is in electrically conducting association with one surface of this substrate, and this first electrode is an alloy of this invention. In addition, this substrate has at least one second metallic electrical contact electrode that in electrically conducting association with one surface of this substrate, and each of the second electrodes is in spaced, adjacent relationship to the first electrode. Also, each of said second electrodes is comprised of an ohmic metal (that is, a metal that displays uniform resistance when varying amounts of current and voltage are passed therethrough).

Preferably the substrate is comprised of gallium arsenide, although suitable substrates also include, for example, aluminum arsenide and aluminum gallium arsenide. Preferred first contact electrodes are comprised of preferred alloys of this invention as defined above. Preferred devices of this invention are thermally stable after being annealed at a temperature of at least about 800°C for at least about 10 minutes.

Examples of suitable ohmic metals include indium, an alloy of gold and germanium, an alloy of gold, germanium, and nickel, and the like.

The substrate is typically doped. Various conventional doping agents, such as selenium and the like can be used.

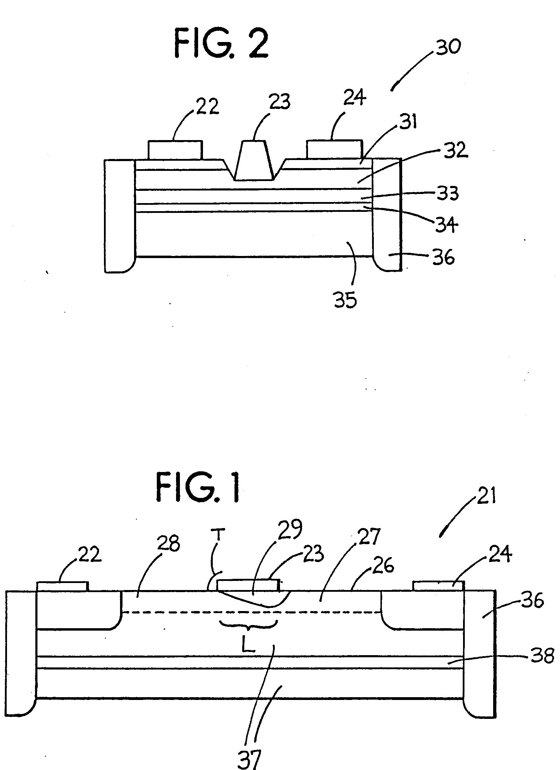

Referring to Fig. 1, there is seen an illustrative embodiment of a solid state integrated circuit (IC) device which utilizes an alloy of this invention as a component electrical contact thereof. Here, an n-channel depletion mode GaAs MESFET device 21 is shown in a simplified, schematic, vertical, cross-sectional view. Device 21 incorporates source 22, gate 23 and drain 24 electrodes (or contacts) in spaced, adjacent relationship to one another on a common surface 26 of a GaAs single crystalline substrate 27. Gate 23 is comprised of at least one alloy of this invention and has a gate length L typically ranging between about 0.5 and 1.0 µm (micrometers) and a gate thickness T typically ranging between about 0.1 and 0.2 µm in thickness. However, larger and smaller lengths and thicknesses can be used if desired. A gate 23 so formed of an alloy of this invention displays characteristically the voltage dependent resistance or rectifying characteristics that are characteristic of Schottky barrier layers and Schottky diodes generally.

The source 22 and drain 24 contacts can have similar dimensions. These contacts can be comprised of metals or alloys previously used in the prior art of GaAs MESFETS and which characteristically display constant resistance, and exhibit linear I-V behavior, as is characteristic of prior art ohmic contacts. For example, these contacts can be comprised of an alloy of Au/Ge/Ni (gold/germanium/nickel), or the like.

Conduction takes place in a surface-adjacent channel 28 within substrate 27 whose thickness is variable, but is believed to be typically in the range of about 0.75 to about 1 µm. The gate contact 23 forms a Schottky barrier with the channel 28. When zero bias is applied to gate 23, the inherent or built-in voltage of the barrier depletes a portion of the channel 28 of material carriers, as illustrated by region 29 in Fig. 1. When gate 23 has a positive bias applied thereto with respect to the channel 28, the depletion region 29 is narrowed and the channel 28 is more conductive.

However, at some voltage, which is typically about 0.7 V (volts) in a prior art MESFET device, a significant forward current begins to flow in the Schottky diode and no further increase in channel 28 conductance is obtained. When gate 23 has a negative bias applied thereto with respect to the channel 28, the thickness of the depletion region 29 increases until it extends through the entire thickness of the channel 28, and the channel 28 conductance declines to zero.

In the MESFET device field, the bias voltage at which this occurs is sometimes known as the "pinch-off" voltage. The MESFET device 21 is typically peripherally surrounded by a zone 36 that is doped with a conventional isolation implant and the GaAs substrate 37 beneath layer 27 is semi-insulating. If desired, a layer 38 can be positioned in substrate 37 to provide a conventional insulating barrier.

The threshold voltage for a depletion mode MESFET device of this invention is now believed to be in the range of about -0.3 to about -3V, and to be in the range of about 0 to about +0.3V for an enhancement mode MESFET device of this invention, which ranges are similar to corresponding prior art MESFET devices.

However, when the gate 23 is comprised of an alloy of this invention, a MESFET of this invention (compared to a prior art MESFET) can be annealed at a higher temperature (up to about 800°C). Thus, the dopants in regions 31 and 32 are fully activated. Also, series resistances through gate, source, and drain regions are reduced. The MESFET also runs at a higher clock speed, if desired.

The alloys of this invention are also useful in modified MESFET devices, such as, for example, the so called high electron mobility transistor (HEMT) which is also called MODET (for modulation doped field effect transistor). Alloys of this invention avoid the reduced temperature limitations associated with prior art HEMTs so that significant speed improvement at relatively high operation temperatures (compared, for example, to MESFETs) is achievable.

A cross sectional view of a HEMT 30 is shown in Fig. 2. Here, as in Fig. 1, the source, drain and gate electrodes are designated by the respective numbers 22, 24 and 23 and are each comprised of similar alloys. Layer 31 is typically from 0 to about 1 nm in thickness and is comprised of n⁺ doped GaAs. Layer 32 is similar in thickness and is comprised of n⁺ doped AlGaAs. Layer 33 is of similar thickness and is comprised of undoped AlGaAs. Layer 34 is of similar thickness and is comprised of GaAs which has been doped. Layer 35 is thicker and is comprised of undoped GaAs. The HEMT 30 is conveniently surrounded peripherally by a zone 36 that is doped with a conventional isolation implant.

Thus, in HEMT 30, a heavily doped AlGaAs layer 32 is placed adjacent to an undoped GaAs channel layer 33. Because electron potential energy is lower in the GaAs layer 33, electrons "fall" into the lightly doped GaAs channel 32. In layer 32, electron mobility is higher due to the lower doping level.

At room (ambient) temperatures and above, the HEMT has a mobility advantage over the MESFET.

### (e) Device Fabrication

The electrical contacts provided by depositing and annealing an alloy of this invention upon a substrate as characterized herein can be incorporated into a wide variety of solid state devices, as those skilled in the art will appreciate. Examples include Schottky-barrier diodes, MESFETs, HEMTs, and other devices employing metal contacts as gate electrodes or Schottky barriers.

A device of this invention incorporating an alloy of this invention as a surface electrical contact on a gallium arsenide (GaAs) semiconducting substrate is characterized by superior high temperature stability, increased yield, and improved reliability. Shallower functions and reduced contact resistance are achieved. The existing (prior art) yield of GaAs devices of not over about 50% is substantially increased by the alloy/GaAs contacts of the present invention.

One class of product device comprises transistors where, in each transistor, a first portion of the substrate assembly is a collector and a second portion of the substrate assembly is an emitter. At least one of the contacts is in electrically conducting association with the collector and at least one other of the contacts is in electrically conducting association with the emitter.

A Schottky barrier diode made with a GaAs substrate and an alloy contact of this metal as the Schottky barrier can be used in combination with conventional ohmic contacts, such as contacts compressed of indium, gold-germanium, or the like. The substrate is conventionally doped n- beneath the alloy contact and beneath the ohmic contact is conventionally doped n+.

Schottky barrier diodes, as those skilled in the art will appreciate, can be either the vertical type or the horizontal type. The following illustrative vertical type diode structure is illustrative:
(1) Starting material: n type, (100) oriented, medium Te-doped (approximately 3x10⁻¹⁷), 2 degrees toward (110), double-side polished GaAs substrate.
(2) Cleaning: GaAs wafers are decreased in trichloroethylene (TCE) using an ultrasonic cleaner followed by two acetone rinses for about 5 minutes each. The wafer is subsequently rinsed by DI water. The wafers are then rinsed in about a 1:5 solution of HCl:DI water for about 2 minutes followed by a 5 minute rinse in deionized water to remove the native oxide.
(3) Thin-film deposition: An alloy of this invention is deposited on the front opposed side of the wafer by sputtering using a procedure such as earlier described herein. Indium is deposited on the back side of the wafer to be an ohmic contact.
(4) Heat-treatment: The wafer is heat-treated at about 200 degrees C to form an ohmic contact on the backside of the wafers. The wafer are then annealed at elevated temperatures to activate the dopants. In this invention, this temperature can be as high as about 800°C with a good yield being achieved for the devices thus made.
(5) Lithography: The front side of each wafer is photo-lithographically processed by standard lithography procedures. Diodes thus made had dimensions in the range of about 150 to about 1200 microns. Smaller diodes can also be made if desired.

The fabrication of, for example, an embodiment of a planar n-channel GaAs MESFET of this invention, such as shown in Fig. 1, involves many of the same process steps that are used with silicon ICs including substrate cleaning, oxidizing, masking, etching, implanting, annealing, metalizing and dicing. These steps have been previously used in the manufacture of prior art MESFETs and so are known to the prior art.

Because of the desire to achieve high speed operational capability for a GaAs MESFET of this invention which employs an alloy of this invention, the fabrication methods used are preferably optimized and the minimum dimensions used preferably about 1 µm or less. The basic simplicity of the MESFET structure facilitates control of such small geometries, but the production of commercially acceptable delineation, reproducible line widths and adequate alignment accuracy requires accurate microlithographic techniques including such techniques as reduction projection photolithography with direct on-wafer stepping, direct writing E-beam pattern generation and/or x-ray replication. Since gallium arsenide wafers and chips are more fragile than those of silicon, they preferably have smaller diameters, such as about 2 or 3 inches.

To fabricate a GaAs MESFET of this invention, a set of masks can be employed as follows.
Mask 1 for implanting channel doping. Silicon or selenium is implanted as the dopant to a level of about 10¹⁷ cm⁻³ for the conducting channels of the MESFETs which results in a final sheet resistance of the indepleted channel of about 1,000 to about 2,000 SL (ohms) per square.
Mask 2 for source and drain doping. A sulfur implantation is common for the n⁺ source and drain contact regions producing a sheet resistance of about 100 to about 200 SL per square. A controlled thermal anneal cycle at about 800°C to about 850°C electrically activates the first two implants.
Mask 3 for ohmic contacts. Areas where ohmic metal makes contact to source and drain doped areas of the substrate are defined. Suitable prior art metal alloys are identified above.
Mask 4 for isolation area doping. Isolation of adjacent IC devices is achieved by implanting ions of hydrogen or boron in regions between adjacent devices with the result that resistivity in the isolation regions is increased.
Mask 5 for gate contacts and connections thereof with source and drain contacts. The Schottky barrier gates and connections between such gates and source and drain contacts are made with an alloy of this invention that is initially deposited over the entire surface of the masked wafer. Mask 5 removes all metal except in gate areas and in connections to sources, gates and drains.
Mask 6 for contact windows. The wafer is covered with an insulating layer of Si0₂ or Si₃N₄. Windows are opened over all desired connection areas.
Mask 7 for metal interconnections. A second layer of conventional ohmic metal or alloy is deposited over the entire surface of the wafer. The final mask patterns this metal to produce the desired circuit connections. After wafer probing and dicing, the devices are ready for packaging, storage or use.

The fabrication procedure for making a HEMT device such as shown in Fig. 2 is substantially more complex than the fabrication procedure for making a MESFET device of Fig. 1, involving molecular beam epitaxy (MBE) and metalorganic chemical vapor deposition (MOCVD) to form the alternating layers of GaAs and AlGaAs each with greatly different respective doping concentrations relative to one another.

To make a HEMT, the following procedure is suitable:
(1) Starting material: wafer of semi-insulating single crystalline GaAs substrate (Cr-doped).
(2) Cleaning: very similar to that described for Schottky barrier diode.
(3) Thin-film deposition of GaAs and AlGaAs: use either MBE or CVD. For MBE, the procedure can start with the oxide decomposition at about 580°C at ultra-high vacuum for about 5 minutes. The temperature of the substrates is then raised to about 630°C to about 700°C and deposited onto the substrate of the same stack, as shown in Fig. 2.
(4) Thin-film deposition of alloys of this invention: alloys of this invention can be deposited onto the stack produced by the preceding deposition procedure of (3) by sputtering. The gate portion of the wafer is masked by a photoresist layer. Other parts of the alloy are etched out. An ohmic metal layer (In or Au-Ge-Ni) is deposited on the whole wafer face. Source and drain regions are masked by photoresist, and other parts of the ohmic alloy are etched out. Removal of the photoresist reveals a shape as shown in Fig. 2.

In a MESFET device of this invention, the substrate is preferably coated with a first doped layer comprised of n+ doped AlGaAs and the first metallic contact electrode is formed on the first doped layer. Also, in spaced adjacent relationship to the first contact electrode, the first doped layer is coated with a second doped layer comprised of n+ doped GaAs, and the first one and the second one of each of the two second metallic contact electrodes are both formed on the second doped layer.

It is a distinct feature and advantage of this invention that the inventive alloys can be used in prior art semiconductor device fabrication techniques that have previously been employed in the manufacture of integrated circuits and solid state devices involving substrates such as herein described.

### Embodiments

The following Examples further illustrate the invention:

### Examples 1.1-1.3. Preparation of Ni(AlₓGa₁₋ₓ) Alloys

Two different alloys of Ni(AlₓGa₁₋ₓ) were prepared by the following procedure:

Ni(Ga,Al) intermetallic alloys were made by a hot-pressed method. Particle sizes of the alloys were approximately 300 mesh for each of the NiAl and NiGa powders. The NiAl powders were purchased from Cerac Co. The NiGa powders were prepared by several steps, as follows:

First, equal amounts of pure Ni and pure Ga were weighed and sealed into quartz tubes. The sealed samples were annealed at 600°C for 1 day to allow the Ga to react completely with the Ni and then each sample was first annealed at 1200°C, which is above the melting temperature of the NiGa intermetallic compound, for 10 minutes and then held at 600°C for 1 month to remove any segregation that might have occurred during the solidification process. Each NiGa intermetallic alloy compound produced was then ground into the powder state. Desired amounts of the respective NiGa and NiAl powders were mixed together in a 2'' structured graphite die, and put into a hot-press furnace. Hot-pressing temperatures ranged from 1050°C for the NiGa alloy to 1400°C for the NiAl alloy. Each alloy composition was hot-pressed at a pressure of 600 psi for 4 hours. The finished alloy composition were each in the form of a tablet 2'' in diameter and 1/8'' thick. Graphite molds were used because they do not react with the alloys of this invention at high temperatures, and they do not deform at the high temperatures and pressures employed.

Analysis of each product showed each alloy corresponded to the formula Ni(AlₓGa₁₋ₓ). In the product designated Example 1.1, the value of x was 0 (that is, the product was NiGa). In the product designated Example 1.2, the value of x was 0.5 (that is, the product was Ni(Al_{0.5}Ga_{0.5})).

In addition, another starting alloy was obtained from the Cerac Company, which, for convenience of identification, was designated Example 1.3. In this alloy, and using the foregoing alloy formula therefor, the value of x was 1 (that is, this alloy was NiAl).

Before hot-pressing, each of the alloys of Examples 1.1, 1.2 and 1.3 was in the physical form of a fine black powder.

### Example 2. Deposition of Preformed Alloys on GaAs by Sputtering

Single crystalline wafers of GaAs were obtained commercially from Wacker Chemie. After solvent cleaning, each substrate was coated by sputtering with each of the alloys of Examples 1.1-1.3 above using Iontek sputtering equipment and conditions as hereinabove described and using the lithographic application procedure described in "VLSI Technology", S.M. Sze, page 141-181, McGraw-Hill Book Co., 1988.

The sputtering conditions and product characteristics were as summarized in Table II below. Each such substrate was cleaved using a diamond scriber into several pieces for analytical use purposes.

**TABLE II**

| | | | |
|---|---|---|---|
| NiGa/GaAs | NiGa phase Single phase | Melts when Temp >600°C | No reaction until 800°C |
| Ni(Ga_{.5}/Al_{.5}) GaAs | Ni(Ga_{.5}-Al₅) Single phase | Smooth up to 800°C | Limited reaction at 800°C |
| NiAl/GaAs | NiAl Single phase | Balls up at Temp >600°C | Extensive reaction when Temp > 600°C |

### Example 3. Annealing

Each of the substrates prepared as described in Example 2 (above) was annealed at temperatures ranging from 300°C to 800°C for times ranging from 10 minutes to 1 hour. The annealing conditions for each substrate are summarized below in Table III:

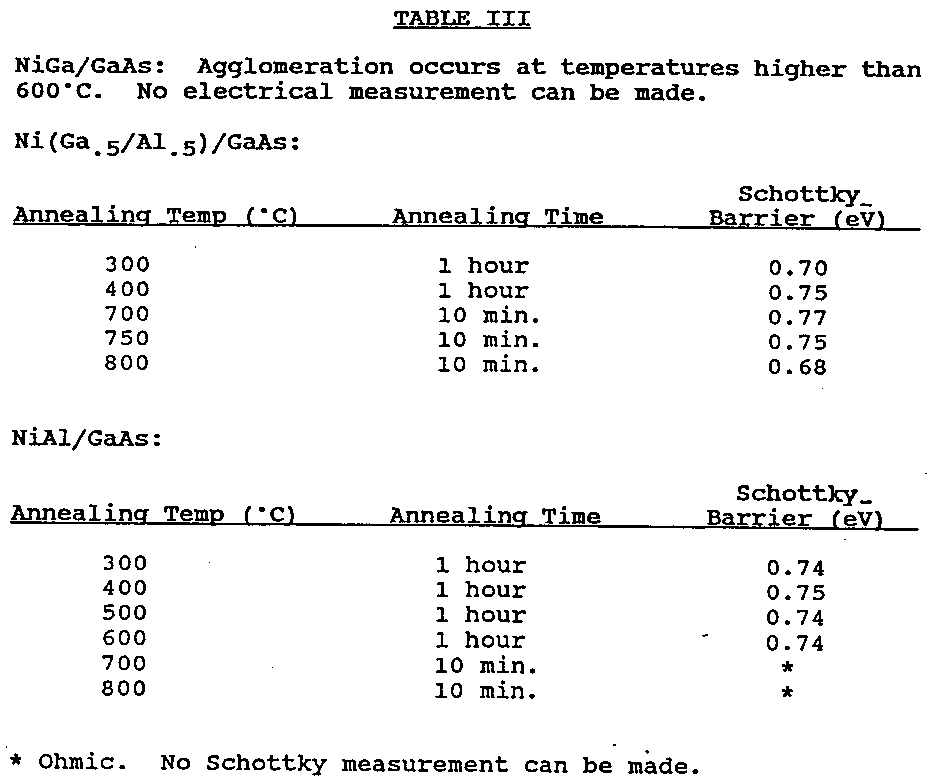

### Example 4. Alloy Characterization

Some of the annealed products prepared as described in Example 3 above were characterized by:
SEM (Scanning Electron Microscopy);
TEM (Transmission Electron Microscopy);
XRD (X-ray Diffraction); and
SAM (Scanning Auger Microscopy).
Others of these products were patterned by lithography for electrical measurements.

The procedures used are described in "Fundamentals of Surface and Thin Film Analysis" by L. C. Feldman and J. W. Mayer and in "Principles of Analytical Electron Microscopy" by D. C. Ivy, A. D. Romig, Jr. and J. I. Goldstein, Plenum press (1986).

### Example 4.1. SEM Surface Morphology

Thermal effects on surface morphologies of the Ni(AlₓGa₁₋ₓ)/GaAs contacts prepared as described in Examples 2 and 3 (above) were studied with SEM secondary electron images of surfaces for the annealed samples.

For NiGa thin-films (derived from Example 1.1), surface morphologies remained smooth and continuous after annealing for 1 hour below 600°C, which is in agreement with the study by Guivarc'h et al. referred to above. The films became discontinuous when annealed at 700°C. When annealed at 800°C, agglomeration of the films occurred.

For Ni(Al_{0.5}Ga_{0.5}) thin-films (derived from Example 1.2), surface morphologies were smooth and continuous up to 600°C. For annealing temperatures higher than 600°C, dark patches were found on the annealed thin-films although they still maintained smooth morphologies. Circular bubbles and dark patches were observed on the thin-films annealed at 800°C for ten minutes.

For NiAl thin-films (derived from Example 1.3), the surfaces were featureless for annealing up to 400°C. Circular bubbles were found for annealing temperatures higher than 500°C. After annealing at 800°C, fine dark textures were found on the thin-films.

An SEM micrograph was prepared from a sample which was ultra-rapidly quenched from 800°C in order to peel away the NiAl thin-film. This micrograph revealed the features underlying the bubbles and the texturized patches. Such features may be due to oxide incorporation during the deposition process, as elemental Al is very easy to oxidize.

On the basis of the foregoing SEM data, the alloy of Example 1.2 above is best because of its surface morphology characteristics.

### Example 4.2. TEM and Electron Diffraction Analysis

A TEM study was carried out on the NiGa (Example 1.1 alloy) and NiAl (Example 1.3) contacts to GaAs. The plan-view bright field TEM image and the electron diffraction pattern for the as-deposited NiGa/GaAs contact show the formation of polycrystalline NiGa film. Continuous rings were indexed as NiGa, which indicates that the co-sputtered film is polycrystalline NiGa which is randomly oriented.

The plan-view bright field TEM image and electron diffraction pattern of the NiGa/GaAs contacts annealed for 1 hr. at 600°C show that the grain size of NiGa is larger than that in the as-deposited NiGa/GaAs contacts which indicates the formation of polycrystalline NiGa film during annealing. Continuous rings were indexed as NiGa, which indicates that the co-sputtered film is polycrystalline NiGa which is randomly oriented.

The plan-view bright field TEM image and electron diffraction pattern of the NiGa/GaAs contacts annealed for 1 hr. at 600°C show the grain size of NiGa is larger than that in the as-deposited sample, which indicates the grains have grown as the temperature increased. Also, the NiGa grains in the TEM image texture in one direction. It was observed that the continuous rings in the diffraction patterns became discontinuous and more intense in the regions near spots from GaAs than in other regions. This indicates that the film has become oriented after high temperature annealing, which is consistent with the observation in the TEM images.

Plan-view bright field TEM images and electron diffraction patterns for the NiAl/GaAs samples in the as-deposited state and after annealing at 600°C indicate that information obtained from the TEM analysis of NiAl/GaAs is the same as that for NiGa/GaAs.

Although, as reported above, MBE grown NiAl and NiGa films have been produced, it was here found that such films were not epitaxial to GaAs substrates. In this study, the metallic thin-films were deposited in a regular vacuum chamber and the substrate holder did not have the capability to heat up the substrates. Therefore, the native oxides herein could not be removed prior to the deposition of the thin-films developed, and the GaAs substrates could not become templates for the epitaxial growth of the deposited thin-films. Additionally, since the present substrates were at room temperature during the deposition of the thin-films produced, deposited Ni and Ga (or Al) atoms might not have had enough energy for surface diffusion to the appropriate lattice sites, which is very crucial to the formation of epitaxial films.

All the alloys elevated were found to have similar lattice parameters so that electron diffractions revealed only limited distinctions between alloys.

### Example 4.3. AES Compositional Profiles

An AES analysis was used to identify the compositions of the reaction products in thin-film Ni(Al,Ga)/GaAs contacts using two as-deposited composition profiles and 600°C annealed NiGa/GaAs contact profiles, respectively. In the as-deposited sample, there was only limited penetration of the component profile of a NiGa/GaAs sample annealed at 600°C for 1 hr. The NiGa film remained inert to GaAs at this temperature. This confirms the previous observation that NiGa is chemically stable to GaAs, based on the Ni-Ga-As phase-diagram.

AES composition profiles of NiAl/GaAs contacts which were annealed at 600°C and 800°C, respectively, were also studied. In the 600°C annealed sample, only limited interaction between the NiAl film and the GaAs substrate can be seen. In the composition profile of NiAl/GaAs samples annealed at 800°C for 1 hour, the component elements Al and Ga were observed to have penetrated the GaAs and NiAl sides, respectively, while the concentrations of component elements As and Ni remain constant. This indicates that the Al-Ga exchange reaction occurs extensively at temperatures higher than 600°C, which may be due to the strong temperature dependence of the interdiffusion coefficients in the two end phases.

NiAl was found to have extensive reaction with GaAs substrate at 800°C. NaAl_{0.5}Ga_{0.5} was found to be much less reactive than NiAl at 800°C. Therefore, the latter alloy is superior to NiAl as an electrode alloy on a GaAs substrate.

### Example 4.4. Electrical Characterization

Schottky barriers of the NiAl and Ni(Al_{0.5}Ga_{0.5}) contacts to (001)n-GaAs as a function of annealing temperatures were studied by current flux (A/cm²) versus voltage measurements. For annealing temperatures of 400°C, 750°C and 800°C, current flux remained linear for increases in voltage from 0 to about 0.6 volts for Ni(Al_{0.5}Ga_{0.5}) in voltage from 0 to about 0.6 volts for Ni(Al_{0.5}Ga_{0.5}) contacts on a GaAs substrate.

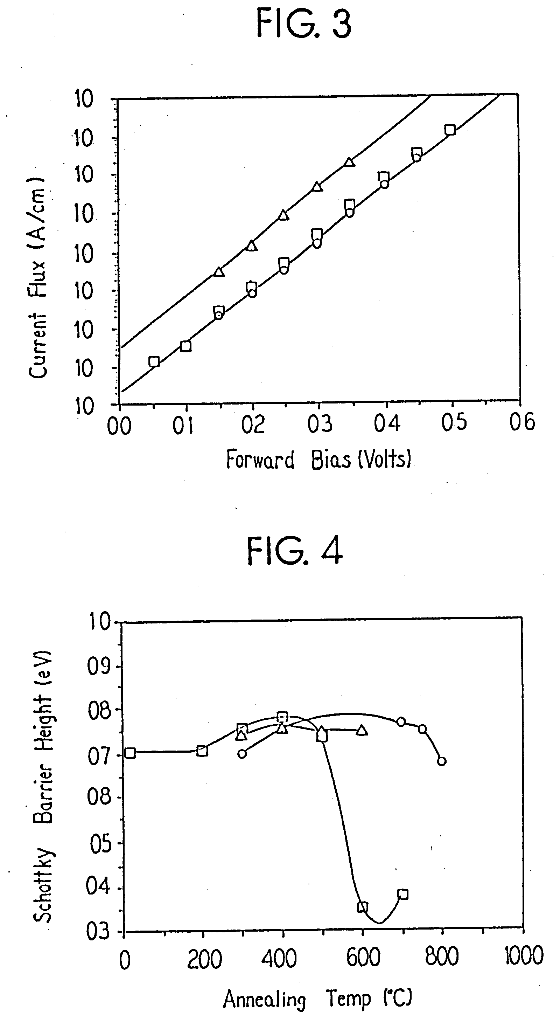

Typical I-V and C-V results are shown in Fig. 3 wherein measured Schottky barrier heights are shown plotted as a function of annealing temperature. Schottky barriers of Ni/GaAs contacts are also shown in Fig. 4 for comparison. Note that, in contrast to the Ni/GaAs contact where the electrical behavior degraded at temperatures as low as 400°C, the NiAl/GaAs contact remained rectifying up to about 600°C. If the processing temperatures were higher than 600°C, the NiAl/GaAs contact became ohmic. However, in contrast, the Ni(Al_{0.5}Ga_{0.5})/GaAs contact was rectifying contrast, the Ni(Al_{0.5}Ga_{0.5})/GaAs contact was rectifying after exposure to temperatures up to 800°C for 10 minutes during annealing.

Based on the work reported above in Examples 4.1 through 4.4, it is concluded that:
(a) alloys of this invention are substantially nonreactive with GaAs substrates yet bond well to surface portions of such substrates to achieve useful electrical contact therebetween;
(b) alloys of this invention display rectifying characteristics which show voltage-dependent resistance and thus are suitable for use as Schottky barrier layers;
(c) compared to prior art NiAl alloys and NiGa alloys, the alloys of this invention display superior non-reactivity toward GaAs single crystalline substrate surfaces at elevated temperatures and superior thermal stability characteristics at elevated temperatures;
(d) the electrical behavior of electrical contacts formed on GaAs with alloys of this invention such as Ni(Al_{0.5}Ga_{0.5}) is superior to the electrical behavior of electrical behavior of electrical contacts made with prior art alloys such as NiAl and NiGa after being annealed at elevated temperatures; and
(e) the test structure of Example 4 is a so-called Schottky diode. The results obtained in Example 4 are directly applicable to a device of Fig. 1, for example.

Other and further embodiments will be apparent to those skilled in the art. No undue limitations are to be drawn from the foregoing description.

## Claims

1. An alloy for use as an electrical contact with a semiconductor substrate having the formula Al_{z}Ga_{1-z} wherein z is a positive number ranging from and including 0 through 1 inclusive, said alloy being represented by the formula:
[ΣM](AlₓGa₁₋ₓ)
where ΣM is at least one Group VIII metal selected from the group consisting of Ni, Co, Ru, Rh and Ir, and x is a positive number between 0 and 1.

2. The alloy of claim 1 wherein x is greater than about 0.35 and less than about 0.60.

3. The alloy of claim 1 wherein x is about 0.5.

4. The alloy of claim 1 wherein [ΣM] is [M¹_{y}M²_{1-y}] where M is as above defined, M¹ is different from M², and y is a positive number of 0 through 1 inclusive.

5. The alloy of claim 4 wherein M¹ is nickel and y is 1.

6. The alloy of claim 4 wherein M¹ is cobalt and y is 1.

7. The alloy of claim of 4 wherein M¹ is nickel and M² is cobalt.

8. The alloy of claim 1 wherein [ΣM] is [M¹_{y}M²₂M³_{1-y-z}] where y is a positive whole number between 0 and 1; z is a positive whole number between 0 and 1, the sum of y, z and [1-y-z] in any given compound is always 1, and M¹, M² and M³ are each different from others thereof.

9. An alloy of claim 1 in the form of a layer having a thickness in the range of about 40 to about 200 nm.

10. A semiconductor device comprising in combination:
(a) a semiconductive monocrystalline substrate having the formula AlᵥGa₁₋ᵥAs wherein v is a positive number ranging from and including 0 through 1 inclusive;
(b) at least one first metallic electrical contact electrode that is in electrically conducting association with one surface of said substrate, said first contact electrode being an alloy of claim 1; and
(c) at least one second metallic electrical contact electrode that is in electrically conducting association with one surface of said substrate, each one of said second contact electrodes being in spaced, adjacent relationship to said first contact electrode, and said second contact electrode being comprised of an ohmic metal.

11. The device of claim 10 wherein said semiconductor substrate is gallium arsenide.

12. The device of claim 10 wherein said semiconductor substrate is selected from the group consisting of gallium arsenide, aluminum arsenide and aluminum gallium arsenide.

13. The device of claim 10 where, in said alloy, x is greater than about 0.35 and less than about 0.60, and y is 1; and, in said substrate, v is 0.

14. The device of claim 10 where, in said alloy, x is about 0.5 and y is 1; and in said substrate v is 0.

15. The device of claim 10 wherein said alloy M is independently selected from the group consisting of nickel and cobalt.

16. The device of claim 15 wherein said alloy M is cobalt.

17. The device of claim 15 wherein said alloy M is nickel.

18. The device of claim 10 wherein said contact is thermally stable after said device is annealed at a temperature of at least about 800°C for a time of the least about ten minutes.

19. The device of claim 10 wherein said contact is a thin layer comprised of Ni(AlₓGa₁₋ₓ) and said substrate comprises gallium arsenide.

20. The device of claim 10 which is a transistor wherein a first portion of said substrate is a collector and a second portion of said substrate is an emitter, and at least one of said contacts is in electrically conducting association with said collector and at least one other of said contacts is in electrically conducting association with said emitter.

21. The device of claim 10 which functions as a Schottky barrier diode.

22. The device of claim 10 which is a MESFET and which incorporates two of said second electrodes and wherein
- said first metallic contact electrode functions as a gate;
- a first one of said second electrode functions as a source; and
- the second one of said second electrode functions as a drain.

23. The device of claim 22 wherein said substrate is coated with a first doped layer comprised of n+ doped AlGaAs and said first metallic contact electrode is formed on said first doped layer, and wherein, in spaced adjacent relationship to said first contact electrode, said first doped layer is coated with a second doped layer comprised of n+ doped GaAs, and each of said first one and said second one of said second metallic contact electrodes are formed on said second doped layer.

24. The device of claim 10 wherein said ohmic metal is selected from the group consisting of indium, an alloy of gold and germanium, and an alloy of gold, germanium and nickel.

25. A process for preparing an alloy of the formula:
[ΣM](AlₓGa₁₋ₓ)
where ΣM is at least one Group VIII metal selected from the group consisting of nickel, cobalt, ruthenium, rhodium and group consisting of nickel, cobalt, ruthenium, rhodium and iridium, and x is a number between 0 and 1, said process comprising the steps of:
(a) admixing together substantially pure aluminum, gallium and at least one metal of said M group, said metals being in a finely divided powdered form, the respective mole ratios of said M group metals, said aluminum and said gallium in the resulting mixture being such that said resulting mixture has a composition that is within the scope of the alloys of said formula;
(b) compressing said resulting mixture under a pressure of about 500 to about 800 pounds per square inch so as to form at least one pellet comprised of said resulting mixture;
(c) sealing said pellet in an inert chamber zone whose interior gas phase pressure is in the range of about 10⁻³ to about 10⁻⁵ Torr;
(d) annealing said pellet in said chamber zone at a temperature in the range of about 1050°C to about 1400°C for a time in the range of about 30 to about 360 hours and thereafter cooling;
(e) removing said pellet from said chamber zone and pulverizing said pellet into a powder;
(f) recompressing said powder under a pressure of about 500 to about 800 pounds per square inch so as to form at least one resulting pellet comprised of said powder;
(g) sealing said resulting pellet in an inert chamber zone whose interior gas phase pressure is not more than about 10⁻⁴ Torr;
(h) reannealing said resulting pellet in said chamber zone at a temperature in the range of about 600°C to about 800°C for a time of about 3 to about 30 days; and
(i) quenching the so annealed pellet in a liquid quench medium that is maintained at a temperature in the range of about 0 to about 5°C.

26. A process for preparing an alloy of the formula:
[ΣM](AlₓGa₁₋ₓ)
where ΣM is at least one Group VIII metal selected from the group consisting of nickel, cobalt, ruthenium, rhodium and iridium and x is a number between 0 and 1, said process comprising the steps of:
(a) simultaneously separately sputtering independent respective starting metals comprising:
(1) at least one metal of said group M,
(2) aluminum and
(3) gallium,
the sputtering rate for each said starting metal corresponding to the amount of said metal in an alloy of said formula; and
(b) codepositing said so sputtered metals to produce an alloy of said formula upon a selected surface area of a semiconductive single crystalline substrate compound of the formula AlᵥGa₁₋ᵥAs wherein v is a number ranging from and including 0 through 1 inclusive.

27. In an improved method of preparing an electrical contact on a semiconductor substrate which comprises a compound of at least one Group III element and at least one Group V element, the improvement comprising the steps of:
depositing on at least one localized surface portion of said substrate a layer of an alloy that is represented by the formula [ΣM] (AlₓGa₁₋ₓ where ΣM is at least one Group VIII metal selected from the group consisting of Ni, Co, Ru, Rh and Ir and x is a positive number between 0 and 1; and
annealing the resulting so layered substrate at a temperature and for a time sufficient to form an electrical contact between said surface portion and said so deposited alloy.

28. The method of claim 27 wherein said depositing is accomplished by sputtering of a preformed said alloy.

29. The method of claim 27 wherein said annealing is performed in a vacuum.

30. The method of claim 27 wherein said annealing employs a temperature of at least about 800°C and a time of at least about 10 minutes.

31. The method of claim 27 wherein said depositing is localized by a photolithographic procedure.

32. An alloy consisting essentially of [ΣM] (AlₓGa₁₋ₓ) where ΣM is at least one of Ni, Co, Ru, Rh and Ir and x is between 0 and 1.
